# EUROPÄISCHE PATENTSCHRIFT

(11) **EP 0 867 074 B1**
(45) Veröffentlichungstag und Bekanntmachung des Hinweises auf die Patenterteilung: **12.05.1999**
(21) Anmeldenummer: 96942164.3
(22) Anmeldetag: 03.12.1996
(51) Int. Cl.: H03M 7/30, H03M 7/00

(54) **VERFAHREN ZUR KOMPRESSION EINES ANALOGEN SIGNALS**
METHOD OF COMPRESSING AN ANALOGUE SIGNAL
PROCEDE DE COMPRESSION D'UN SIGNAL ANALOGIQUE

(30) Priorität: 04.12.1995 AT 1976/95
(43) Veröffentlichungstag der Anmeldung: 30.09.1998
(73) Patentinhaber: ERICSSON AUSTRIA AKTIENGESELLSCHAFT, 1121 Wien (AT)
(72) Erfinder: ZIMMERMANN, Gerhard, A-1100 Wien (AT)
(74) Vertreter: Gibler, Ferdinand, Dipl.Ing. Dr. techn.
(86) Internationale Anmeldenummer: AT9600241
(87) Internationale Veröffentlichungsnummer: WO9721274

(56) Entgegenhaltungen:
- US-A- 4 727 506
- US-A- 4 870 685
- PATENT ABSTRACTS OF JAPAN vol. 009, no. 043 (E-298), 22.Februar 1985 & JP 59 182639 A (SANSUI DENKI KK), 17.Oktober 1984,
- PATENT ABSTRACTS OF JAPAN vol. 015, no. 020 (P-1154), 17.Januar 1991 & JP 02 264300 A (RICOH CO LTD), 29.Oktober 1990,

## Beschreibung

Die Erfindung betrifft ein Verfahren zur Kompression eines analogen Signals, z.B eines Sprachsignals, wobei die Signalfunktion laufend abgetastet, quantisiert und in Datenwörter kodiert sowie jeweils die Differenz zweier aufeinanderfolgender Datenwörter gebildet wird, sodann jeder Differenzwert quantisiert und kodiert wird, wobei aus dem Datenwortstrom laufend eine vorbestimmbare Anzahl der kodierten Datenwörter als Gruppe gespeichert und nacheinander jede Gruppe gemäß den Schritten a) bis c) bearbeitet wird:
a) daß in einer sich für jedes Datenwort der Gruppe wiederholenden Rechenoperation jeweils die Differenz zweier aufeinanderfolgender Datenwörter berechnet wird,
b) daß der Maximalwert der Differenzwerte einer Gruppe bestimmt und diesem ein niederwertiger Skalierungsfaktor zugeordnet wird,
   daß in einer sich für jedes Datenwort der Gruppe wiederholenden Rechenoperation der Schritt ausgeführt wird, wobei
c) ein korrigierter Differenzwert aufeinanderfolgender Datenwörter der Gruppe durch die Subtraktion jeweils des vorhergehenden Datenwortes gebildet wird, das Ergebnis jeweils mit einer vom Skalierungsfaktor abhängigen Skalierungsfunktion skaliert, quantisiert und zu einem niederwertigen Deltawert kodiert wird, welcher Deltawert dann mit den anderen so errechneten Deltawerten und dem Skalierungsfaktor der Gruppe weiterverarbeitet wird.

Bekannte Verfahren dieser Art, die beispielsweise für Sprachkompression und Sprachkodierung in Übertragungssystemen verwendet werden, erreichen eine Verbesserung der Übertragungsqualität durch eine Steigerung der Komprimierungsraten, wodurch aber der erforderliche Implementierungsaufwand steigt. Die in der Nachrichtentechnik verwendeten Verfahren sind als CCITT bzw. ITU-Standards genormt. Dabei stellt die A-law und U-law-Kodierung für den PCM-Standard der Telephonie bei 64 kBit/s die Referenzübertragungsqualität dar. Die Normen G722, G726 für ADPCM bei 32 kBit/s und G728 für LD-CELP bei 16 kBit/s erreichen gute Übertragungsqualität, während die Norm G730 für GSM bei 13 kBit/S nur als weniger gute Qualität eingestuft werden kann.

Die in verschiedenen Druckschriften geoffenbarten Verbesserungen zu den existierenden Kompressionsverfahren betreffen eine Erhöhung des Kompressionsfaktors unter Beibehaltung der Qualität, eine Reduzierung der Übertragungsfehler unter Beibehaltung des Kompressionsfaktors oder die Übertragung zusätzlicher Informationen im Sprachdatenstrom.

Der Nachteil dieses Standes der Technik besteht darin, daß die Verbesserung der Sprachqualität durch einen Mehraufwand an Hardware bzw. ein aufwendigeres Programm, welches einen schnelleren Signalprozessor erfordert, erreicht wird.

Die SU-PS-1107308 beschreibt ein Datenübertragungssystem mit FehlerprädidionssignalKompression auf der Basis eines DPCM (Deltamodulations)-Verfahrens, wobei das Sprachsignal gefiltert und umgewandelt wird, um daraus lineare Prädiktions-Koeffizienten und die Prädiktionsfehlerenergie zu berechnen. Die linearen Prädiktionssignale werden in einen Verzerrungsrechner eingegeben, der auch Kodeworte für die wahrscheinlichsten Kombinationen von linearen Prädiktionskoeffilzienten von einem ROM erhält. Der Kodewort-Index, der der minimalen Verzerrung entspricht, wird für den Multiplexer kodiert. Dieses Verfahren setzt jedoch eine entsprechend hohe Rechnerleistung voraus.

Die JP-A-59 182639 (Patent Abstr. of Jap. vol.9, no.43, 1985) offenbart ein DPCM-Kompressionsverfahren mit einer geringen Fehlerrate, bei dem aus einem PCM-Datenstrom durch Differenzbildung zwischen den aufeinanderfolgenden Datenwörtern zunächst 16-bit DPCM-kodierte Daten geformt und zu Gruppen zusammengefaßt werden. Für jede Gruppe wird mittels eines Detektors eine Skalierungsinformation gewonnen. Die Datenkompression geschieht durch nachfolgendes Bitverschieben der einzelnen Differenzwerte einer Gruppe in Abhängigkeit von der im Detektor ermittelten Skalierungsinformation, weiters durch Ausgabe der höherwertigen 8 Bits und durch Anfügen der abgerundeten niederwertigen Bits an das nächste DPCM-Wort. Zur Dekompression wird eine Dekodierung und eine Umkehrskalierung sowie eine Integration der deskalierten Datenwörter vorgenommen.

Weiters werden bekannte Kompressionsverfahren auch in Sprachspeichersystemen eingesetzt. Um die Speicherkapazität eines Sprach-Mail-Systems zu verkleinern, werden Sprachdaten mit verschiedenen Kodieralgorithmen (ADPCM, GSM, LD-CELP usw.) komprimiert. Diese Kompressionsverfahren bieten eine niedrige Kodierverzögerung verbunden mit niedrigen Speicher-Datenraten. Ein Hauptnachteil dabei ist aber die hohe Prozessorleistungsanforderung für die Algorithmen, sodaß die Anzahl der gleichzeitig zur Verfügung stehenden Sprachkanäle beschränkt ist.

Aufgabe der Erfindung ist es daher, die für ein Verfahren der eingangs genannten Art erforderliche Rechnerleistung zu verringern.

Eine weitere Aufgabe ist es, ein Verfahren anzugeben, mit dem unter Beibehaltung der Übertragungsqualität und der Rechnerleistung eine Erhöhung der Anzahl der Übertragungssprachkanäle erreicht werden kann.

Erfindungsgemäß wird dies dadurch erreicht, daß innerhalb der sich für jedes Datenwort der Gruppe wiederholenden Rechenoperation jedes Datenwort nach dem Schritt c) gemäß den Schritten d) bis f) bearbeitet wird:
d) daß der jeweilige Deltawert wieder dekodiert und anhand des zugehörigen Skalierungsfaktors (S) mit der entsprechenden Umkehrskalierungsfunktion deskaliert wird,
e) daß jeder deskalierte Differenzwert jeweils zum im vorhergehenden Rechenschritt ermittelten Alt-Datenwort hinzuaddiert wird, und
f) daß das so errechnete neue Alt-Datenwort im nachfolgenden Rechenschritt c) bzw. e) als Alt-Datenwort des vorhergehenden Rechenschrittes verwendet wird.

Durch die Anwendung dieses erfindungsgemäßen Verfahrens kann auf komplexe Berechnungen wie z.B. bei ADPCM, verzichtet und dafür durch einfache Rechenoperationen wie Addition und Subtraktion ersetzt werden. Die sonst üblichen Vorhersagealgorithmen werden durch die Analyse aktueller Daten ersetzt, wodurch sich eine hohe Genauigkeit ergibt. Die dabei in Kauf zu nehmende Zeitverzögerung ist etwa bei Sprachspeicheranwendungen ohne Belang. Es können weiters auch signalangepaßte Quantisierungsstufen verwendet werden, indem etwa für die bei Sprachsignalen häufigeren niederfrequenten Signalanteile eine kleinere Quantisierungsstufung vorgenommen wird.
Im wesentlichen kann die erforderliche Rechenleistung für die Kompression reduziert werden, sodaß dieses erfindungsgemäße Verfahren besonders für digitale Sprachspeicher geeignet ist.

Das Signal wird im erfindungsgemäßen Verfahren nach dem Kodieren gleich wieder dekodiert, um mögliche Abweichungen mit dem nächsten Quantisierungsvorgang mitzukompensieren.

Eine weitere Aufgabe der Erfindung ist es, ein Verfahren der eingangs genannten Art für sich langsam ändernde analoge Signale anzugeben, mit welchem bei gleicher Rechnerleistung die Information komprimiert werden kann, ohne daß eine merkbare Zeitverzögerung auftritt.

Dies wird erfindungsgemäß dadurch erreicht, daß im Schritt b) der Maximalwert der Differenzwerte der vorhergehenden Gruppe zur Zuordnung eines niederwertigen Skalierungsfaktors für die aktuelle Gruppe verwendet wird, und innerhalb der sich für jedes Datenwort der Gruppe wiederholenden Rechenoperation jedes Datenwort nach dem Schritt c) gemäß den Schritten d) bis f) bearbeitet wird:
d) daß der jeweilige Deltawert wieder dekodiert und anhand des zugehörigen Skalierungsfaktors (S) mit der entsprechenden Umkehrskalierungsfunktion deskaliert wird,
e) daß jeder deskalierte Differenzwert jeweils zum im vorhergehenden Rechenschritt ermittelten Alt-Datenwort hinzuaddiert wird, und
f) daß das so errechnete neue Alt-Datenwort im nachfolgenden Rechenschritt c) bzw. e) als Alt-Datenwort des vorhergehenden Rechenschrittes verwendet wird.

Dadurch wird der bei einer vorhergehenden Gruppe errechnete Skalierungsfaktor jeweils gleich als Skalierungsfaktor für die aktuelle Gruppe verwendet, sodaß nicht erst die Berechnung des Skalierungsfaktors abgewartet werden muß, um die Skalierung der Differenzwerte durchzuführen. Auf diese Weise kann eine Zeitverzögerung verhindert werden, Voraussetzung für eine solche Anwendung des jeweils vorhergehenden Skalierungsfaktors ist ein sich nicht abrupt änderndes Signal. Diese Bedingung ist gewöhnlich für einen normalen Gesprächston erfüllt.

Gemäß einer anderen Variante der Erfindung kann vorgesehen sein, daß die Skalierungsfunktion durch Division und die Deskalierungsfunktion durch Multiplikation mit dem Skalierungsfaktor gebildet ist, wobei die Division durch n bzw. die Multiplikation mit n durch n-faches bitweises Rechts- bzw. Linksverschieben durchgeführt wird.

Diese Verschiebeoperationen sind besonders einfach zu verarbeiten und beanspruchen daher nur sehr wenig Rechenleistung.

Ein weiteres Merkmal der Erfindung kann darin bestehen, daß die Skalierungsfunktion durch Potenzbildung zur Basis 2 gebildet ist.

Dadurch läßt sich eine hohe Rechengeschwindigkeit erreichen, da diese Rechenoperation durch einfaches Bitverschieben durchgeführt werden kann.

Dies schwächt den Einfluß sehr großer Skalierungsfaktoren entsprechend ab.

Gemäß einer anderen Variante der Erfindung kann vorgesehen sein, daß zur Kompression für jeden skalierten Differenzwert aus einer Quantisierungstabelle eine diesem Wert zugeordnete Quantisierungsstufe ausgelesen wird und zur Dekompression jedem kodierten Wert über eine Dekodierungstabelle ein dekodierter Wert zugeordnet wird.

Durch die Verwendung von Tabellen können aufwendige Rechenoperationen eingespart werden.

Weiters kann ein Merkmal der Erfindung darin bestehen, daß die Stufen der Quantisierungstabelle bzw. der Dekodierungstabelle im wesentlichen entsprechend den Stufen eines Histogramms eines lauten Sprachstückes gewählt werden.

Dies wirkt sich besonders vorteilhaft auf die Sprachqualität aus, da durch die Vorskalierung alle Signalteile eher zu lauten Signalen werden.

Gemäß einer anderen Variante der Erfindung kann vorgesehen sein, daß in Schritt b) dem Maximalwert der Differenzwerte ein Skalierungsfaktor aus einer Skalierungstabelle zugeordnet wird.

Durch die Anwendung einer Skalierungstabelle können aufwendige Rechenoperationen eingespart werden. Die Skalierungstabelle kann den jeweiligen Erfordernissen angepaßt werden.

In weiterer Ausbildung der Erfindung kann vorgesehen sein, daß der Skalierungsfaktor so zugeordnet wird, daß der größte zur Verfügung stehende Quantisierungssprung 80% des größten Differenzwertes erreicht.

Dies ist bei einer groben Stufung bei großen Deltawerten vorteilhaft, da sonst leicht ein Überschießen durch fehlende Zwischenwerte stattfinden kann. Dies würde zu akustisch unangenehmen, ungeraden Harmonischen flüren.

Gemäß einer anderen Variante der Erfindung kann vorgesehen sein, daß zur Dekompression des komprimierten Signals in einer sich für jedes Datenwort der Gruppe wiederholenden Rechenoperation die Schritte d) und e) sowie ein Schritt f1) durchgeführt werden, welcher darin besteht
f1) daß das so errechnete neue Alt-Datenwort (TRACK) im Rechenschritt e) der nachfolgenden Rechenoperation als Alt-Datenwort (TRACK) des vorhergehenden Rechenschrittes verwendet wird.

Die Erfindung wird im folgenden anhand von in den Zeichnungen dargestellten Ausführungsbeispielen ausführlich beschrieben. Es zeigt dabei:
Fig. 1 eine schematische Darstellung eines erfindungsgemäßen Verfahrens;
Fig.2 bis 5 schematische Darstellungen von Ausführungsformen des erfindungsgemäßen Verfahrens;
Fig.6 ein Histogramm der Differenzwerte eines Sprachsignals;
Fig.7 ein Histogramm der Differenzwerte eines lauten Sprachstückes;
Fig.8 ein Histogramm eines für das erfindungsgemäße Verfahren optimierten Signals und
Fig.9 eine Ausführungsform einer Schaltungsanordnung zur Durchführung des erfindungsgemäßen Verfahrens.

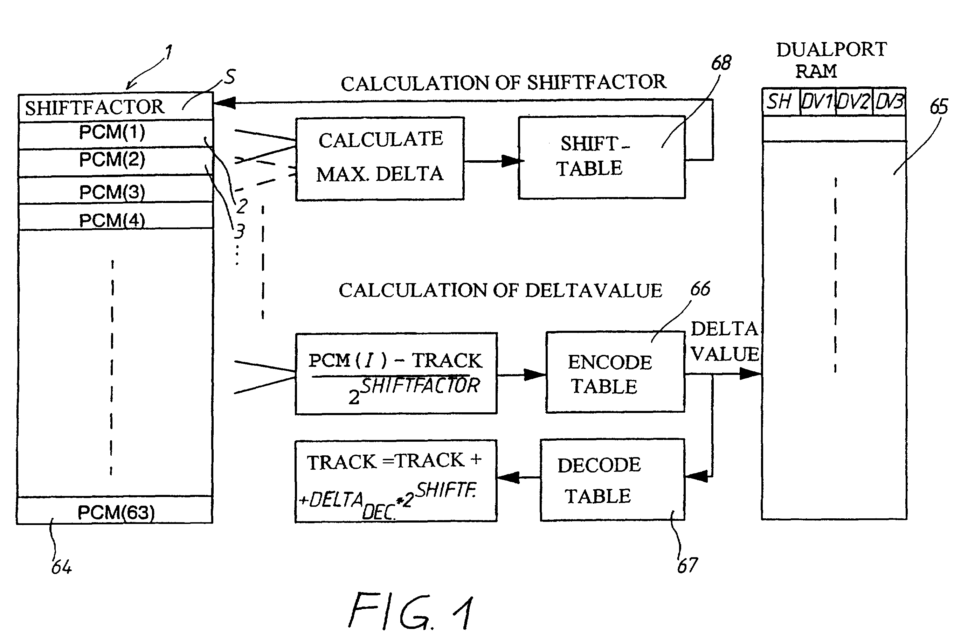

Der in Fig. 1 dargestellte schematische Verfahrensablauf bezieht sich auf ein Deltamodulationsverfahren zur Kompression eines analogen Signals, z.B eines Sprachsignals, wobei die Signalfunktion laufend abgetastet, quantisiert und in Datenwörter kodiert sowie jeweils die Differenz zweier aufeinanderfolgender Datenwörter gebildet wird, sodann jeder Differenzwert quantisiert und kodiert, z.B. PCM-kodiert, wird.

Zur Dekompression der so komprimierten Daten wird der Differenzwert zum vorhergehenden, berechneten Datenwort addiert und der entstehende Wert dekodiert und zu einem analogen Signal zusammengesetzt. Dies entspricht der üblichen Vorgangsweise bei Deltamodulation.

Das analoge Signal ist zum Zwecke der Erläuterung der Erfindung ein Sprachsignal, es kann aber jedes andere analoge Signal ebenso erfindungsgemäß komprimiert werden.

So haben PABX-Systeme gemäß dem Stand der Technik die Aufgabe, Sprachsendungen für Nachrichthinterlegungen, Mitteilungen und Sprachsendungen, z.B. für Mailbox-Systeme, usw. aufzuzeichnen und auf Abruf wiederzugeben. Diese Sendungen sind gewöhnlicherweise in digitalen Systemen, die als Speichermedium ein RAM, eine Festplatte oder ein Flash-ROM aufweisen, gespeichert, die den gleichzeitigen Betrieb mehrerer Sprachkanäle ermöglichen.

Um beispielsweise die Speicherkapazität eines Sprach-Mail-Systems zu erhöhen, werden üblicherweise Sprachdaten mit verschiedenen Kodieralgorithmen (ADPCM, GSM, LD-CELP usw.) komprimiert. Diese Kompressionsverfahren bieten eine niedrige Kodierverzögerung verbunden mit niedrigen Datenraten zum Speicher. Ein Hauptnachteil besteht aber in den hohen Anforderungen an die Prozessorleistung für die Berechnung der diesen Kompressionsverfahren zugrundeliegenden Algorithmen.
Um die Anzahl der gleichzeitig zur Verfügung stehenden Sprachkanäle zu erhöhen, ist es notwendig, die erforderliche Prozessorleistung pro Kanal zu verkleinern.
Dies wird mit dem in Fig. 1 dargestellten erfindungsgemäßen Verfahren verwirklicht, welches in seiner Qualität mit einem bekannten ADPCM-Verfahren vergleichbar ist. Das Leistungsvermögen wird gegenüber dem ADPCM-Verfahren jedoch dadurch gesteigert, daß eine Datenanalyse mit den Echtzeit-Sprachdaten durchgeführt wird und dabei weniger Rechnerleistung erforderlich ist.
Das erfindungsgemäße Verfahren besteht dabei aus den folgenden Schritten:

Aus dem Datenwortstrom wird laufend eine vorbestimmbare Anzahl der kodierten Datenwörter 2, 3,.., 64 als Gruppe 1 gespeichert und nacheinander jede Gruppe 1 gemäß den Schritten a) bis f) bearbeitet:
a) Es wird in einer sich für jedes Datenwort der Gruppe wiederholenden Rechenoperation jeweils die Differenz zweier aufeinanderfolgender Datenwörter 2, 3,.., 64 berechnet.
b) Der Maximalwert der Differenzwerte einer Gruppe 1 wird bestimmt und diesem ein niederwertiger Skalierungsfaktor S zugeordnet.

Dies wird in dem Funktionsblock "Calculate max. delta" durchgeführt, woraufhin der errechnete Wert mit Hilfe einer Tabelle 68 dem jeweiligen niederwertigen Skalierungsfaktor zugeordnet wird. Niederwertig bedeutet in diesem Zusammenhang, daß aus relativ langen höherwertigen Datenwörtern eine kurze, niederwertige Dateneinheit, z.B. 4 bit, gebildet wird.

In einer sich für jedes Datenwort der Gruppe 1 wiederholenden Rechenoperation werden die Schritte c) bis f) ausgeführt, wobei die einzelnen Schritte folgendermaßen definiert sind:
c) Es wird ein korrigierter Differenzwert aufeinanderfolgender Datenwörter der Gruppe 1 durch die Subtraktion jeweils eines Datenwortes vom im vorhergehenden Rechenschritt ermittelten Datenwort (track) gebildet, das Ergebnis jeweils mit einer vom Skalierungsfaktor S abhängigen Skalierungsfunktion skaliert. Dies erfolgt in dem in Fig. 1 dargestellten Fall durch die Potenzfunktion mit der Basis 2, sodaß sich für große Werte des Skalierungsfaktors S entsprechend kleine Differenzwerte ergeben. Die solcherart skalierten Differenzwerte werden nun quantisiert, indem für die skalierte Differenz aus der Quantisierungstabelle 66 die Quantisierungsstufe abgelesen und zu einem Deltawert kodiert wird, welcher Deltawert dann mit den anderen so errechneten Deltawerten und dem Skalierungsfaktor S der Gruppe in einem Dualport-RAM 65 gespeichert wird, von wo diese zur weiteren Verarbeitung, z.B. zum Transfer in einen Massenspeicher, z.B. eine Festplatte, abgerufen werden können. Zur Berücksichtigung der Kodierungs/Dekodierungsfehler wird der folgende Schritt d) ausgeführt:
d) Der jeweilige Deltawert wird wieder dekodiert, indem anhand der Dekodierungstabelle 67 der entsprechende Wert ausgelesen wird. Dann wird anhand des zugehörigen Skalierungsfaktors S mit der entsprechenden Umkehrskalierungsfunktion, hier durch Multiplikation mit 2^{S}, deskaliert.
e) Es wird jeder deskalierte Differenzwert jeweils zum im vorhergehenden Rechenschritt ermittelten Datenwort (track) hinzuaddiert.
f) Das so errechnete Datenwort wird im nachfolgenden Rechenschritt c) bzw. e) als Datenwort des vorhergehenden Rechenschrittes (track) verwendet.

Erfindungsgemäß kann auch der für die vorhergehende Gruppe berechnete Skalierungsfaktor für die auf diese folgende Gruppe verwendet werden und dadurch eine Zeitverzögerung durch den Berechnungsvorgang vermieden werden. Dies wird erfindungsgemäß realisiert, indem die vorstehend beschriebenen Schritte durchgeführt werden mit dem Unterschied, daß Schritt b1) anstelle des Schrittes b) durchgeführt wird, welcher umfaßt:
b1) daß der Maximalwert der Differenzwerte der vorhergehenden Gruppe 1 zur Zuordnung eines niederwertigen Skalierungsfaktors S für die aktuelle Gruppe 1 verwendet wird. Die im Ausführungsbeispiel gemäß Fig. 1 verwendete Skalierungsfünktion, welche den Skalierungsfaktor zur Potenz 2 erhebt, kann je nach Bedarf anders gestaltet sein, am einfachsten ist die Skalierung direkt über S, indem die Differenzwerte durch S dividiert und bei der Dekodierung mit S multipliziert werden. Die dabei benötigten Rechenoperationen sind bitweises Rechts- bzw. Linksverschieben.

Das Verfahren zur Dekompression eines erfindungsgemäß komprimierten Signals wird durch Anwendung der Schritte d), e) und f) erreicht.

Das erfindungsgemäße Kompressionsverfahren läßt sich beispielsweise auf 32 kBit/s, 24 kBit/s und 16 kBit/s konfigufieren. Dies läßt sich anhand der im folgenden beschriebenen Ausführungsbeispiele zeigen. Als Vergleichswert kann dabei herangezogen werden, daß der Leistungsverbrauch für ein G.726 ADPCM-Verfahren bei 17 MIPS (Mega instructions/seconds) und für ein G.728 LD-CELP bei 37 MIPS liegt. Mit kommerziellen digitalen Signalprozessoren (DSP) können daher nur ein bis drei Kanäle pro Signalprozessor erzielt werden. Das erfindungsgemäße Verfahren ist unter Beibehaltung einer gegebenen Übertragungsqualität hinsichtlich des Implementierungsaufwandes verbessert und erzielt mit geringem Hardware-Aufwand relativ viele Kanäle eines Sprachspeichersystems. Bei Verwendung des erfindungsgemäßen Kompressionsverfahren für ein Sprachspeichersystem ähnelt dies dem Klang und den meßtechnischen Daten nach dem ADPCM Standard G.726. Kodierer und Dekodierer benötigen typischerweise 2 MIPS DSP Performance. Das erfindungsgemäße Verfahren ist etwa achtmal schneller als ADPCM und benötigt lediglich 300 Bytes/Kanal, was deutlich geringer ist als bei anderen Verfahren wie LDCELP, GSM, die 2kBytes/Kanal benötigen. Es ergibt sich beim erfindungsgemäßen Verfahren jedoch eine relativ hohe Signalverzögerung, die jedoch in Sprachspeichersystemen ohne jede Relevanz ist. Wie vorstehend beschrieben, kann diese Zeitverzögerung auch durch Verwendung des jeweils zuvor berechneten Skalierungsfaktors vermieden werden. Dieses Verfahren ist aber nur für nicht abrupt vor sich gehende Signaländerungen geeignet.

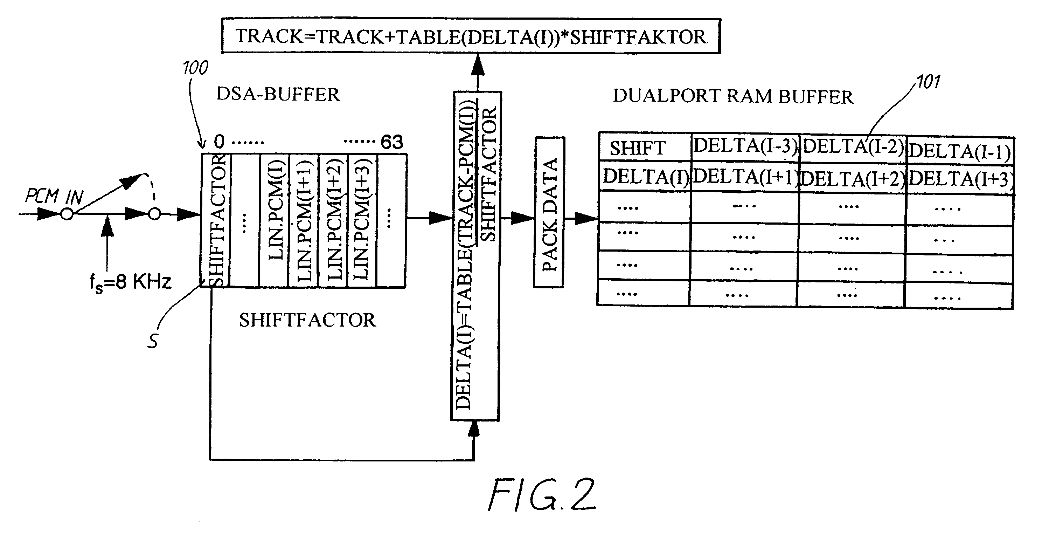

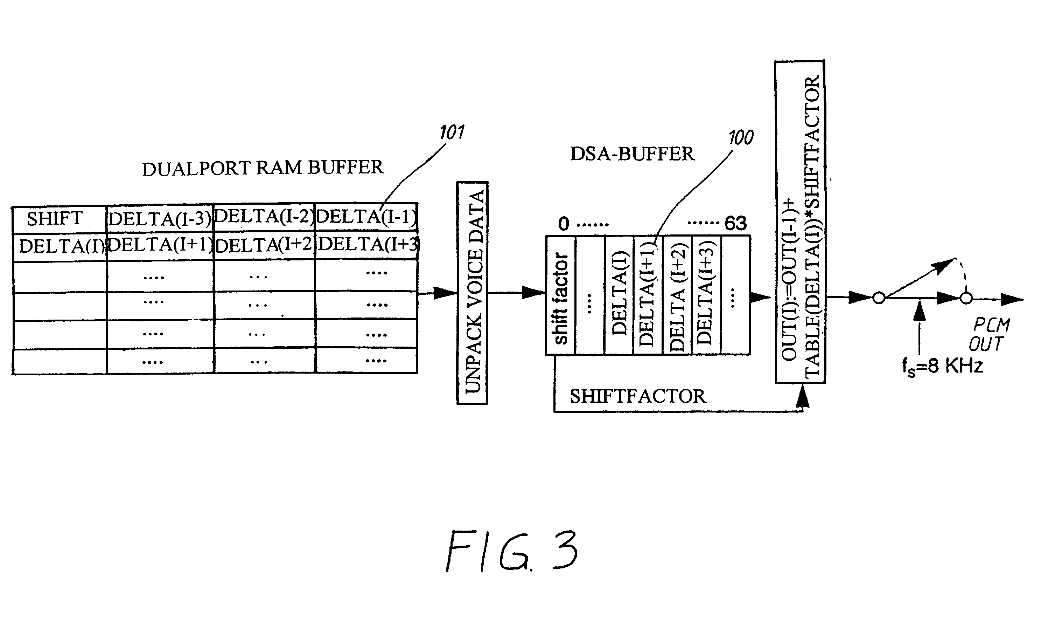

In Fig.2 ist die Programmorganisation eines 32 kbit/s Abspielprogramms für einen Verfahrensablauf zum Aufzeichnen (RECORD) von erfindungsgemäß komprimierten Datenwörtern dargestellt. Es erfolgt ein Komprimieren der Sprachdaten vor dem Abspeichern in einen Dualport-RAM-Puffer 101. Dabei wird entsprechend der üblichen PCM-Abtastrate alle 125µs ein PCM-Sprachdatenwort aus dem PCM-Highway eingelesen und dann linearisiert. Bevor das neue PCM-Wort in einem DSA-Puffer 100 gespeichert wird, der eine Gruppe von Datenworten aufnehmen kann, wird das vorhergehende PCM-Wort an derselben Stelle im DSA-Puffer ausgelesen und in ein Register abgelegt. Diese vorhergehende PCM-Abtastung wird im erfindungsgemäßen Verfahrensschritt c) vom Datenwort, das sich aus den vorhergehenden Rechenschritten c) bis f) ergibt, welches als track bezeichnet ist, subtrahiert, und dann die Differenz skaliert, indem durch den Skalierungsfaktor S dividiert wird. Dies wird durch n-maliges bitweises Rechtsverschieben erreicht, was wenig Rechenaufwand erfordert. n kann in diesem Beispiel abhängig vom Skalierungsfaktor S Werte von 0 bis 5 annehmen. Der Skalierungsfaktor S wird dabei gemäß den Schritten a) und b) bestimmt. Für den sich ergebenden Differenzwert wird ein 4 bit langer Deltawert aus der Quantisierungstabelle ausgelesen. Diese 4 bits werden so zusammengefaßt, daß vier PCM-Datenworte in einem 16 bit-Datenwort enthalten sind. Dieses Wort wird dann im Dualport-RAM-Puffer 101 gespeichert. Wenn das vorhergehende Datenwort gerade der Skalierungsfaktor S war, wird dieser mit den nächsten drei PCM-Datenworten in ein Wort zusammengepackt.
Der Beginn einer eintreffenden Nachricht wird z.B. durch einen Skalierungsfaktor 07h angezeigt, wodurch der Augenblickswert auf Null gesetzt wird.
Das Berechnen des track-Wertes für den nächsten Rechenschritt, erfolgt gemäß den Schritten d) e) und f), wobei der Deltawert anhand der Dekodiertabelle dekodiert und mit dem Skalierungsfaktor S deskaliert, in diesem Fall multipliziert wird, indem bitweises Linksverschieben durchgeführt wird, und jeder deskalierte Differenzwert jeweils zum im vorhergehenden Rechenschritt ermittelten Datenwort (track) hinzuaddiert wird. In Fig.3 sind die Verfahrensschritte zum Abspielen (PLAY) bzw. Dekomprimieren der gespeicherten Daten dargestellt. Dabei werden mit einem 32 kbit/s Abspielprogramm die zusammengefaßten Deltawerte vom Dualport-RAM 101 auseinandergenommen, bevor sie im DSA-Puffer 100 zwischengespeichert werden. Es wird jeweils ein zusammengefaßtes Datenwort vom Dualport-RAM 101 ausgelesen, dann in vier Teilbytes auseinandergenommen und im DSA-Puffer 100 gespeichert, wobei ein Teilbyte auf jeweils einen Platz gelangt. Das erste Wort in diesem Puffer enthält den Skalierungsfaktor. Alle Deltawerte werden als Indexierung für eine Abfrage der Dekodierungstabelle verwendet, um den dekodierten Deltawert zu erhalten, der dann n mal nach links verschoben wird (n= 0 bis 5, abhängig vom Skalierungsfaktor S), bevor sie auf den PCM-Highway gelangen. Alle 125 µs wird ein PCM-Wort auf den Highway geschickt.

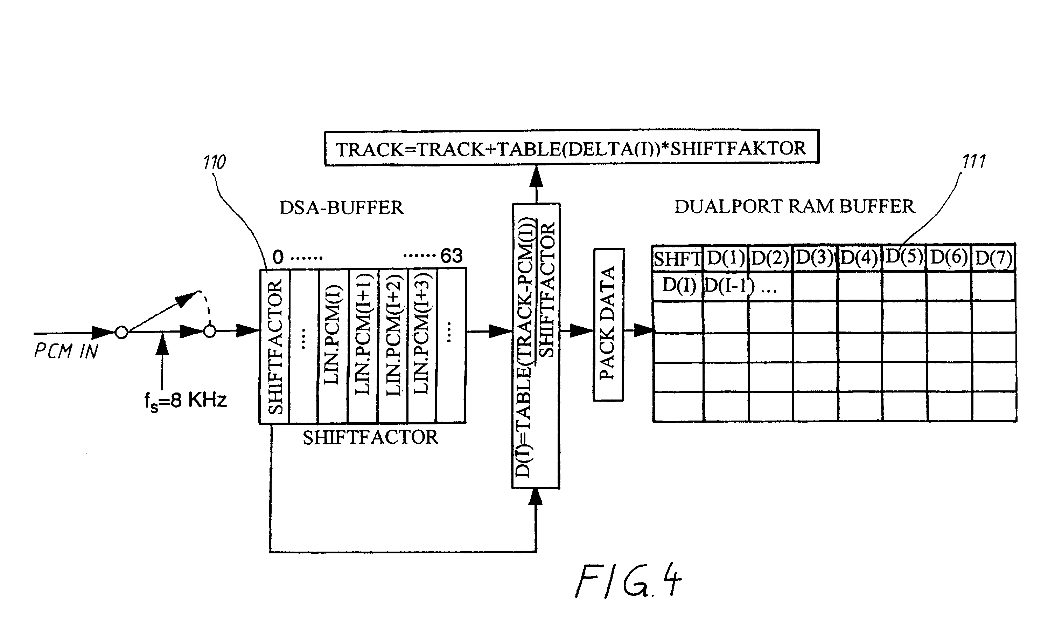

Fig.4 zeigt den Programmablauf eines 16 kbit/s-Programms, mit dem die Sprachdaten gefiltert und zusammengefaßt werden, bevor sie im Dualport-RAM 111 gespeichert werden. Dabei werden Einbyte-A-law-Sprachdaten alle 125 µs aus dem PCM-Highway gelesen. Bevor die neuen linearisierten PCM-Sprachdaten in den DSA-Puffer 110 gespeichert werden, wird die vorhergehende PCM-Sprachabtastung auf derselben Stelle im DSA-Puffer 110 ausgelesen. Diese vorhergehende PCM-Abtastung wird vom Datenwort aus dem vorhergehenden Rechenschritt (track) abgezogen und die Differenz wird n-mal nach rechts verschoben (n=0 bis 3, abhängig vom Skalierungsfaktor). Für den resultierenden Wert wird ein 2 bit Delta-Index aus einer Tabelle ausgelesen. Diese zwei Bits werden zusammengefaßt, sodaß acht PCM-Sprachdatenwörter in einem 16bit-Wort vereint sind. Dieses Wort wird dann im Dualport-RAM-Puffer 111 gespeichert. War das vorhergehende PCM-Datenwort der Skalierungsfaktor, wird dieses mit den nächsten sieben PCM-Sprachdaten in ein Wort zusammengefaßt.

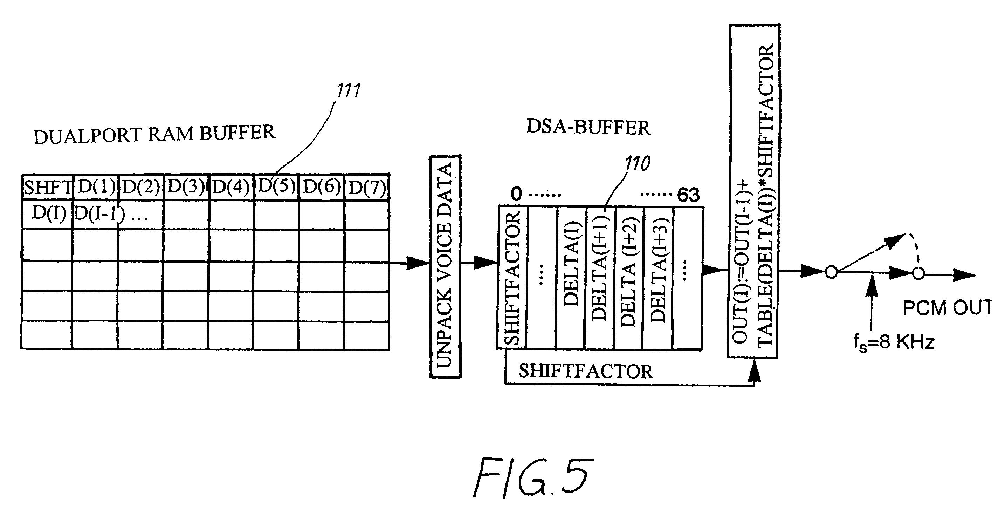

In Fig.5 ist der Ablauf eines 16 kBit/s-Abspielprogramms dargestellt, wobei die zusammengefaßten Sprachdaten vom Dualport-RAM aueinandergenommen werden, bevor sie in den DSA-Puffer eingespeichert werden.
Es werden in einzelnen Datenworten zusammengefaßte Sprachdaten aus dem Dualport-RAM 111 gelesen. Dieses Wort wird auseinandergenommen, indem es in acht 2bit-Teilbytes geteilt wird, und im DSA-Puffer gespeichert wird. Einem Teilbyte entspricht eine Stelle. Das erste Byte in diesem Puffer ist ein Verschiebungsbit. Alle Deltawerte werden als Index für eine Dekodiertabellenabfrage benutzt, um den echten Deltawert zu erhalten, der dann n-mal nach links verschoben wird, bevor sie auf den PCM-Highway gelangen. n geht dabei von 0 bis 3 und hängt vom Skalierungsfaktor S ab. Alle 125µs geht dabei ein PCM-Sprach-Byte auf den PCM-Highway hinaus.
Das erfindungsgemäße Verfahren erlaubt die Verwendung von signalangepaßten Quantisierungsstufen. Da übliche Sprachsignale eher niederfrequente Signalanteile enthalten, treten kleinere Deltastufen häufiger auf. Somit kann die Trefferwahrscheinlichkeit erhöht werden, indem die Quantisierungstabellen mehr kleine als große Stufen enthalten.

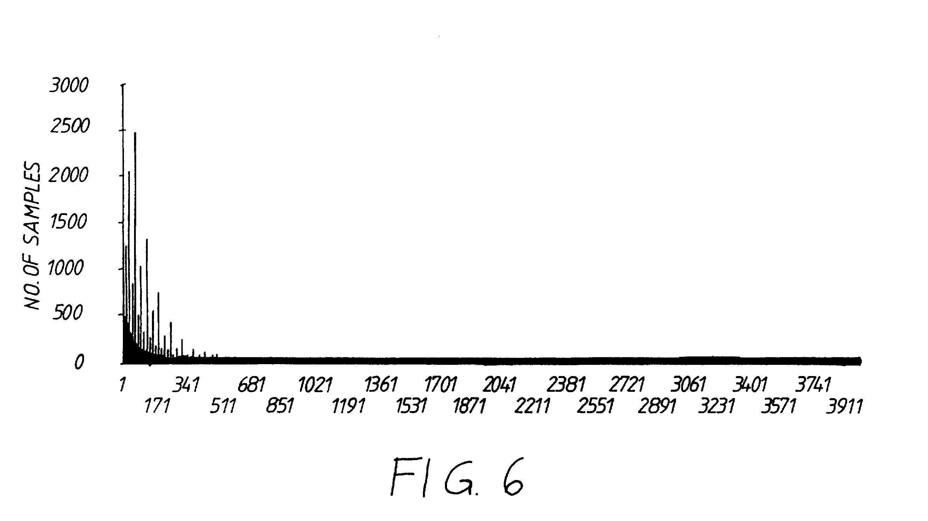

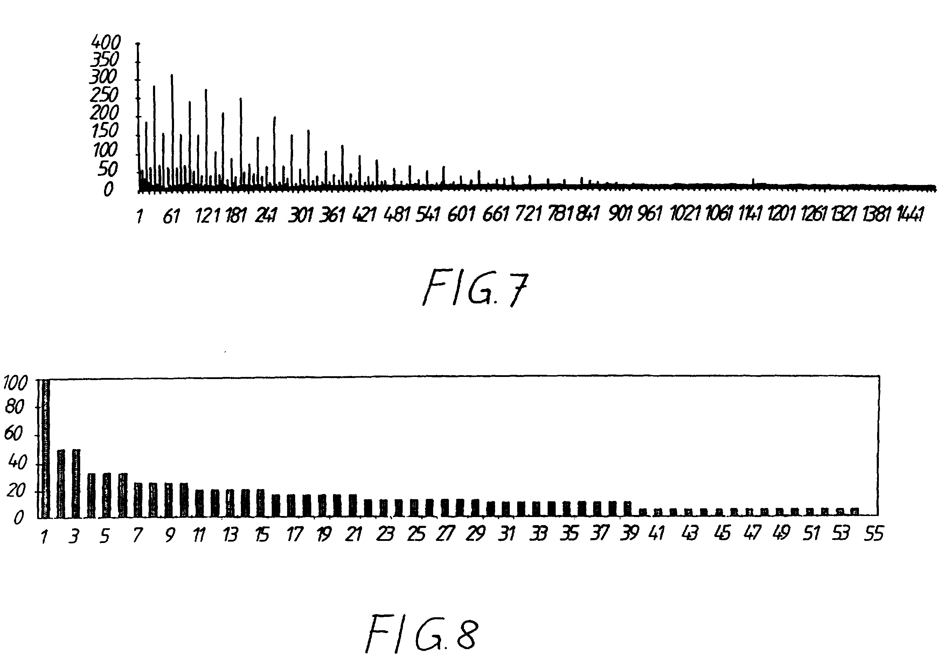

Fig.6 und Fig.7 zeigen dazu Beispiele von Histogrammen der Differenzwerte eines mit normaler Lautstärke gesprochenen Sprachsignals mit drei Worten in A-Law bzw. ein lautes Sprachstück mit dem Vokal A in A-Law vollausgesteuert. Die Y-Achse stellt dabei die Anzahl der Abtastungen und die X-Achse die für A-Law digitalisierten Pegelwerte (+- 4096) dar.
In Fig.8 ist ein Histogramm eines bereits nach dem erfindungsgemäßen Verfahren vorskalierten Sprachsignals wiedergegeben, welches im wesentlichen dem lauten Sprachstück gemäß Fig.7 entspricht, jedoch in Richtung des Sprachstückes gemäß Fig.6 geändert worden ist und das jede Stufe der Quantisierungstabelle mit je acht positiven und negativen Stufen gleich oft, hier hundertmal ausnützt. Die X-Achse läuft entsprechend der Vorskalierung von 0 bis 64. Nach diesem Histogramm aus Fig. 8 wurden die Quantisierungsstufen der Quantisierungstabelle gewählt, sodaß die Stufen der Quantisierungstabelle bzw. der Dekodierungstabelle im wesentlichen entsprechend den Stufen eines Histogramms eines lauten Sprachstückes gewählt werden. Dies begründet sich darin, daß Sprachqualität nur in deutlich wahrnehmbaren Passagen der Wiedergabe vom Hörer eingestuft werden kann. Da sich also einerseits der Klirrfaktor in Sprachpausen nicht sonderlich auswirkt, andererseits durch die Vorskalierung aufgrund des adaptiven Skalierungsfaktors aus allen Signalteilen eher laute Signale werden, wird die Stufenfunktion in die Nähe eines lauten Signals gelegt. Es wird dadurch ein geringer Klirrfaktor erzielt.
Das Zusammenspiel von Skalierungs-, Quantisierungs- und Dekodierungstabelle wird dabei so ausgelegt, daß der durch die Kompression auftretende Klirrfaktor nicht störend klingt, sondern der Wiedergabe nur einen warmen Klang verleiht, sodaß nur geradzahlige Oberwellen, hautsächlich die zweite Harmonische, auftreten. Die Skalierungsfaktortabelle bestimmt den Skalierungsfaktor so, daß der größte zur Verfügung stehende Quantisierungsspung 70% - 90%, vorzugsweise 80% des größten Differenzwertes erreicht. Dies ist günstig, da durch die grobe Stufung bei großen Deltas leicht ein Überschießen durch fehlende Zwischenwerte stattfinden kann. Dies würde zu akustisch unangenehmen, ungeraden Harmonischen führen. Die Quantisierungstabelle ist so ausgelegt, daß der gewählte Deltawert kleiner als der erforderliche ist. Dadurch entsteht aus dem Zusammenwirken von Skalierungsfaktortabelle und Quantisierungs- bzw. Dekodierungstabelle insgesamt ein Tiefpaßcharakter des komprimierten bzw. dekomprimeirten Signals mit dreiecksförmigen Verzerrungsanteilen und somit die Ausbildung gerader Harmonischer, die der Wiedergabe einen akustisch warmen Klang verleihen.

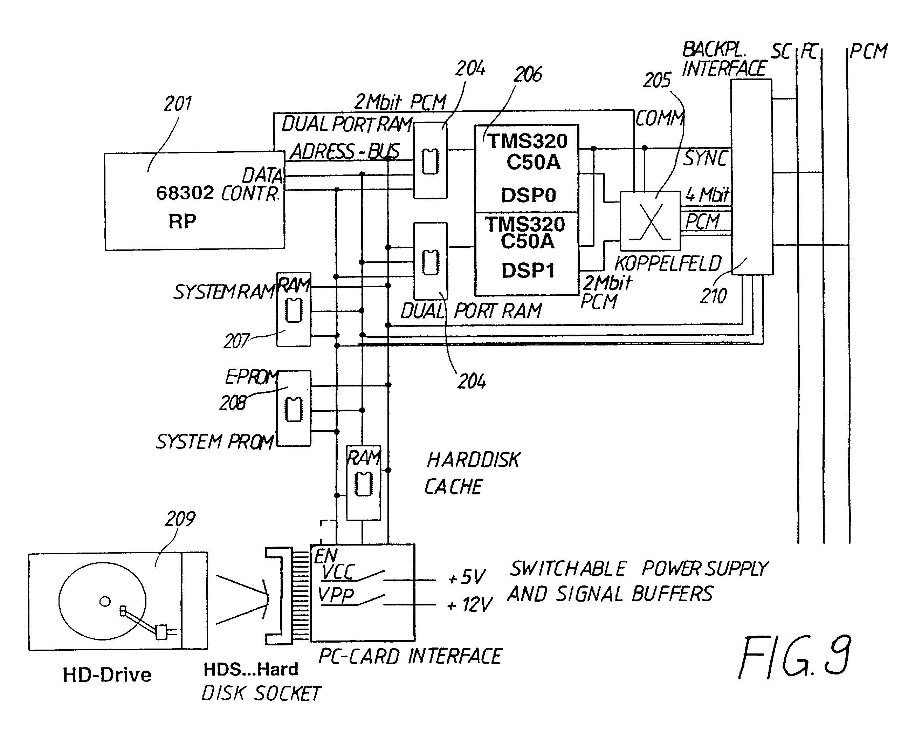

In Fig.9 ist eine Schaltungsanordnung dargestellt, mit der das erfindungsgemäße Verfahren realisiert werden kann. Ein Regionalprozessor 201, z.B. der Type 68302, steuert alle anderen Funktionsblöcke und kommuniziert dabei über seinen Adreß- und Datenbus mit einer Backplane-Schnittstelle 210, über die der PCM-Datenwortstrom einem digitalen Koppelfeld 205 zugeführt wird. Das digitale Koppelfeld 205 setzt die 4Mbit Anlagenbusse auf 2Mbit lokale PCM-Busse für die beiden digitalen Signalprozessoren 206, z.B. TMS320C50A um, die für 20 MIPS ausgelegt sind. Die nach dem erfindnungsgemäßen Verfahren berechneten Daten werden in den Dualport-RAM 204 mit je 1 kWord Speicherumfang abgelegt, um für eine weitere Verarbeitung abrufbar zu sein. Die Quantisierungs- und Dekodierungstabelle ist im System-PROM 208, z.B. ein EPROM, verfügbar.

## Patentansprüche

1. Verfahren zur Kompression eines analogen Signals, z.B eines Sprachsignals, wobei die Signalfunktion laufend abgetastet, quantisiert und in Datenwörter kodiert sowie jeweils die Differenz zweier aufeinanderfolgender Datenwörter gebildet wird, sodann jeder Differenzwert quantisiert und kodiert wird,
wobei aus dem Datenwortstrom laufend eine vorbestimmbare Anzahl der kodierten Datenwörter (2, 3,.., 64) als Gruppe (1) gespeichert und nacheinander jede Gruppe (1) gemäß den Schritten a) bis c) bearbeitet wird:
a) daß in einer sich für jedes Datenwort der Gruppe wiederholenden Rechenoperation jeweils die Differenz zweier aufeinanderfolgender Datenwörter (2, 3,.., 64) berechnet wird,
b) daß der Maximalwert der Differenzwerte einer Gruppe (1) bestimmt und diesem ein niederwertiger Skalierungsfaktor (S) zugeordnet wird,
daß in einer sich für jedes Datenwort der Gruppe (1) wiederholenden Rechenoperation der Schritt c) ausgeführt wird, wobei
c) ein korrigierter Differenzwert aufeinanderfolgender Datenwörter der Gruppe (1) durch die Subtraktion jeweils des vorhergehenden Datenwortes gebildet wird, das Ergebnis jeweils mit einer vom Skalierungsfaktor (S) abhängigen Skalierungsfunktion skaliert, quantisiert und zu einem niederwertigen Deltawert kodiert wird, welcher Deltawert dann mit den anderen so errechneten Deltawerten und dem Skalierungsfaktor (S) der Gruppe weiterverarbeitet wird, **dadurch gekennzeichnet,** daß innerhalb der sich für jedes Datenwort der Gruppe wiederholenden Rechenoperation jedes Datenwort nach dem Schritt c) gemäß den Schritten d) bis f) bearbeitet wird:
d) daß der jeweilige Deltawert wieder dekodiert und anhand des zugehörigen Skalierungsfaktors (S) mit der entsprechenden Umkehrskalierungsfunktion deskaliert wird,
e) daß jeder deskalierte Differenzwert jeweils zum im vorhergehenden Rechenschritt ermittelten Alt-Datenwort (TRACK) hinzuaddiert wird, und
f) daß das so errechnete neue Alt-Datenwort (TRACK) im nachfolgenden Rechenschritt c) bzw. e) als Alt-Datenwort (TRACK) des vorhergehenden Rechenschrittes verwendet wird.

2. Verfahren zur Kompression eines analogen Signals, z.B eines Sprachsignals, wobei die Signalfunktion laufend abgetastet, quantisiert und in Datenwörter kodiert sowie jeweils die Differenz zweier aufeinanderfolgender Datenwörter gebildet wird, sodann jeder Differenzwert quantisiert und kodiert wird,
wobei aus dem Datenwortstrom laufend eine vorbestimmbare Anzahl der kodierten Datenwörter (2, 3,.., 64) als Gruppe (1) gespeichert und nacheinander jede Gruppe (1) gemäß den Schritten a) bis c) bearbeitet wird:
a) daß in einer sich für jedes Datenwort der Gruppe wiederholenden Rechenoperation jeweils die Differenz zweier aufeinanderfolgender Datenwörter (2, 3,.., 64) berechnet wird,
b) daß der Maximalwert der Differenzwerte einer Gruppe (1) bestimmt und diesem ein niederwertiger Skalierungsfaktor (S) zugeordnet wird,
daß in einer sich für jedes Datenwort der Gruppe (1) wiederholenden Rechenoperation der Schritt c) ausgeführt wird, wobei
c) ein korrigierter Differenzwert aufeinanderfolgender Datenwörter der Gruppe (1) durch die Subtraktion jeweils des vorhergehenden Datenwortes gebildet wird, das Ergebnis jeweils mit einer vom Skalierungsfaktor (S) abhängigen Skalierungsfunktion skaliert, quantisiert und zu einem niederwertigen Deltawert kodiert wird, welcher Deltawert dann mit den anderen so errechneten Deltawerten und dem Skalierungsfaktor (S) der Gruppe weiterverarbeitet wird, **dadurch gekennzeichnet,**
daß im Schritt b) der Maximalwert der Differenzwerte der vorhergehenden Gruppe (1) zur Zuordnung eines niederwertigen Skalierungsfaktors (S) für die aktuelle Gruppe (1) verwendet wird, und innerhalb der sich für jedes Datenwort der Gruppe wiederholenden Rechenoperation jedes Datenwort nach dem Schritt c) gemäß den Schritten d) bis f) bearbeitet wird:
d) daß der jeweilige Deltawert wieder dekodiert und anhand des zugehörigen Skalierungsfaktors (S) mit der entsprechenden Umkehrskalierungsfunktion deskaliert wird,
e) daß jeder deskalierte Differenzwert jeweils zum im vorhergehenden Rechenschritt ermittelten Alt-Datenwort (TRACK) hinzuaddiert wird, und
f) daß das so errechnete neue Alt-Datenwort (TRACK) im nachfolgenden Rechenschritt c) bzw. e) als Alt-Datenwort (TRACK) des vorhergehenden Rechenschrittes verwendet wird.

3. Verfahren nach Anspruch 1 oder 2, **dadurch gekennzeichnet**, daß die Skalierungsfunktion durch Division und die Deskalierungsfunktion durch Multiplikation mit dem Skalierungsfaktor gebildet ist, wobei die Division durch n bzw. die Multiplikation mit n durch n-faches bitweises Rechts- bzw. Linksverschieben durchgeführt wird.

4. Verfahren nach Anspruch 1 oder 2, **dadurch gekennzeichnet,** daß die Skalierungsfunktion durch Potenzbildung zur Basis 2 gebildet ist.

5. Verfahren nach Anspruch 1 bis 4, **dadurch gekennzeichnet,** daß zur Kompression für jeden skalierten Differenzwert aus einer Quantisierungstabelle eine diesem Wert zugeordnete Quantisierungsstufe ausgelesen wird und zur Dekompression jedem kodierten Wert über eine Dekodierungstabelle ein dekodierter Wert zugeordnet wird.

6. Verfahren nach Anspruch 5, **dadurch gekennzeichnet**, daß die Stufen der Quantisierungstabelle bzw. der Dekodierungstabelle im wesentlichen entsprechend den Stufen eines Histogramms eines lauten Sprachstückes gewählt werden.

7. Verfahren nach Anspruch 1 bis 6, **dadurch gekennzeichnet,** daß in Schritt b) dem Maximalwert der Differenzwerte ein Skalierungsfaktor (S) aus einer Skalierungstabelle zugeordnet wird.

8. Verfahren nach Anspruch 7, **dadurch gekennzeichnet,** daß der Skalierungsfaktor so zugeordnet wird, daß der größte zur Verfügung stehende Quantisierungssprung 80% des größten Differenzwertes erreicht.

9. Verfahren nach einem der Ansprüche 1 bis 8, **dadurch gekennzeichnet,** daß zur Dekompression des komprimierten Signals in einer sich für jedes Datenwort der Gruppe wiederholenden Rechenoperation die Schritte d) und e) sowie ein Schritt f1) durchgeführt werden, welcher darin besteht
f1) daß das so errechnete neue Alt-Datenwort (TRACK) im Rechenschritt e) der nachfolgenden Rechenoperation als Alt-Datenwort (TRACK) des vorhergehenden Rechenschrittes verwendet wird.

## Claims

1. Method for compressing an analog signal, for example a speech signal, wherein the signal function is continuously sampled, quantized and encoded in data words and in each case the difference between two successive data words is formed and each differential value is then quantized and encoded,
wherein a predeterminable number of encoded data words (2, 3, ..., 64) from the data-word stream are continuously stored as a group (1) and each group (1) is processed one after the other in accordance with steps a) to c):
a) that in an arithmetic operation which is repeated for each data word of the group, the difference between two successive data words (2, 3, ..., 64) is calculated in each case,
b) that the maximum value of the differential values of a group (1) is determined and a low-order scaling factor (S) is allocated thereto,
that in an arithmetic operation which is repeated for each data word of the group (1), step c) is carried out, wherein
c) a corrected differential value of successive data words of the group (1) is formed by the subtraction of the preceding data word in each case, the result is in each case scaled with a scaling function which is dependent on the scaling factor (S), and encoded to form a low-order delta value, which delta value is then processed further with the other delta values calculated in this way and the scaling factor (S) of the group, characterised in that within the arithmetic operation which is repeated for each data word of the group, each data word is, after step c), processed in accordance with steps d) to f):
d) that the respective delta value is decoded again, and is descaled with the aid of the associated scaling factor (S) having the corresponding inverse scaling function,
e) that each descaled differential value is in each case added to the old data word (TRACK) established in the preceding arithmetic step, and
f) that the new old data word (TRACK) calculated in this way is used in the subsequent arithmetic step c) or e) as old data word (TRACK) of the preceding arithmetic step.

2. Method for compressing an analog signal, for example a speech signal, wherein the signal function is continuously sampled, quantized and encoded in data words and in each case the difference between two successive data words is formed and each differential value is then quantized and encoded,
wherein a predeterminable number of encoded data words (2, 3, ..., 64) from the data-word stream are continuously stored as a group (1) and each group (1) is processed one after the other in accordance with steps a) to c):
a) that in an arithmetic operation which is repeated for each data word of the group, the difference between two successive data words (2, 3, ..., 64) is calculated in each case,
b) that the maximum value of the differential values of a group (1) is determined and a low-order scaling factor (S) is allocated thereto,
that in an arithmetic operation which is repeated for each data word of the group (1), step c) is carried out, wherein
c) a corrected differential value of successive data words of the group (1) is formed by the subtraction of the preceding data word in each case, the result is in each case scaled with a scaling function which is dependent on the scaling factor (S), and encoded to form a low-order delta value, which delta value is then processed further with the other delta values calculated in this way and the scaling factor (S) of the group, **characterised in that** in step b), the maximum value of the differential values of the preceding group (1) is used to allocate a low-order scaling factor (S) for the current group (1), and within the arithmetic operation which ie repeated for each data word of the group, each data word is, after step c), processed in accordance with steps d) to f):
d) that the respective delta value is decoded again and is descaled with the aid of the associated scaling factor (S) having the corresponding inverse scaling function,
e) that each descaled differential value is in each case added to the old data word (TRACK) established in the preceding arithmetic step, and
f) that the new old data word (TRACK) calculated in this way is used in the subsequent arithmetic step c) or e) as old data word (TRACK) of the preceding arithmetic step.

3. Method according to claim 1 or claim 2, characterised in that the scaling function is formed by division and the descaling function is formed by multiplication by the scaling factor, with the division by n and the multiplication by n, respectively, being carried out by n-fold bit-by-bit shifting to the right and to the left, respectively.

4. Method according to claim 1 or 2, characterised in that the scaling function is formed by exponentiation to base 2.

5. Method according to claims 1 to 4, characterised in that for the compression, for each scaled differential value, there is read out of a quantization table a quantization step allocated to this value, and for the decompression, a decoded value is allocated to each encoded value via a decode table.

6. Method according to claim 5, characterised in that the steps of the quantization table or of the decode table are selected substantially in accordance with the steps of a histogram of a loud piece of speech.

7. Method according to claims 1 to 6, characterised in that in step b), there is allocated to the maximum value of the differential values a scaling factor (S) from a scaling table.

8. Method according to claim 7, characterised in that the scaling factor is allocated in such a way that the largest available quantization jump reaches 80% of the largest differential value.

9. Method according to one of the claims 1 to 8, characterised in that for the decompression of the compressed signal, steps d) and e) and a step f1), which consists in that
f1) the new old data word (TRACK) calculated in this way is used in the arithmetic step e) of the subsequent arithmetic operation as old data word (TRACK) of the preceding arithmetic step,
are carried out in an arithmetic operation which is repeated for each data word of the group.

## Revendications

1. Procédé de compression d'un signal analogique, par exemple un signal vocal, dans lequel la structure du signal est explorée en continu, quantifiée et codée en mots de données, tandis que la différence entre deux mots de données successifs est chaque fois formée, chaque valeur de différence étant également quantifiée et codée,
dans lequel, à partir du flux de mots de données en continu, un nombre prédéfinissable des mots de données codés (2, 3, ..., 64) est mémorisé en tant que groupe (1) et chaque groupe (1) est successivement traité selon les étapes a) à c) suivantes :
a) dans une opération de calcul, qui se répète pour chaque mot de données du groupe, la différence est chaque fois calculée entre deux mots de données (2, 3, ..., 64) successifs,
b) la valeur maximale des valeurs de différence d'un groupe (1) est déterminée et un facteur de mise à l'échelle (S) d'ordre inférieur lui est associé,
dans une opération de calcul, qui se répète pour chaque mot de données du groupe (1), l'étape c) est exécutée, dans laquelle
c) une valeur de différence corrigée de mots de données successifs du groupe (1) est formée par la soustraction chaque fois du mot de données précédent, le résultat est chaque fois mis à l'échelle par une fonction de mise à l'échelle dépendant du facteur de mise à l'échelle (S), le résultat est quantifié et codé en une valeur delta d'ordre inférieur, laquelle valeur delta est ensuite soumise à la suite du traitement avec les autres valeurs delta ainsi obtenues et avec le facteur de mise à l'échelle (S) du groupe, **caractérisé en ce que,** à l'intérieur de l'opération de calcul, qui se répète pour chaque mot de données du groupe, chaque mot de données est traité, après l'étape c), selon les étapes d) à f) suivantes :
d) la valeur delta correspondante est de nouveau décodée et son échelle est supprimée par la fonction inverse de mise à l'échelle correspondante à l'aide du facteur de mise à l'échelle (S) associé,
e) chaque valeur de différence, à échelle supprimée, est chaque fois ajoutée au mot de données ancien (TRACK), déterminé dans l'étape de calcul précédente, et
f) le nouveau mot de données ancien (TRACK) ainsi calculé est utilisé dans l'étape de calcul suivante c) ou bien e) en tant que mot de données ancien (TRACK) de l'étape de calcul précédente.

2. Procédé de compression d'un signal analogique, par exemple un signal vocal, dans lequel la structure du signal est explorée en continu, quantifiée et codée en mots de données, tandis que la différence entre deux mots de données successifs est chaque fois formée, chaque valeur de différence étant également quantifiée et codée,
dans lequel, à partir du flux de mots de données en continu, un nombre prédéfinissable des mots de données codés (2, 3, ..., 64) est mémorisé en tant que groupe (1) et chaque groupe (1) est successivement traité selon les étapes a) à c) suivantes :
a) dans une opération de calcul, qui se répète pour chaque mot de données du groupe, la différence est chaque fois calculée entre deux mots de données (2, 3, ..., 64) successifs,
b) la valeur maximale des valeurs de différence d'un groupe (1) est déterminée et un facteur de mise à l'échelle (S) d'ordre inférieur lui est associé,
dans une opération de calcul, qui se répète pour chaque mot de données du groupe (1), l'étape c) est exécutée, dans laquelle
c) une valeur de différence corrigée de mots de données successifs du groupe (1) est formée par la soustraction chaque fois du mot de données précédent, le résultat est chaque fois mis à l'échelle par une fonction de mise à l'échelle dépendant du facteur de mise à l'échelle (S), le résultat est quantifié et codé en une valeur delta d'ordre inférieur, laquelle valeur delta est ensuite soumise à la suite du traitement avec les autres valeurs delta ainsi obtenues et avec le facteur de mise à l'échelle (S) du groupe, **caractérisé en ce que,**
dans l'étape b), la valeur maximale des valeurs de différence du groupe précédent (1) est utilisée, pour l'affectation d'un facteur de mise à l'échelle (S) d'ordre inférieur, pour le groupe (1) actuel et en ce que, à l'intérieur de l'opération de calcul, qui se répète pour chaque mot de données du groupe, chaque mot de données est traité, après l'étape c), selon les étapes d) à f) suivantes :
d) chaque valeur delta est de nouveau décodée et son échelle est supprimée par la fonction inverse de mise à l'échelle correspondante à l'aide du facteur de mise à l'échelle (S) associé,
e) chaque valeur de différence, à échelle supprimée, est chaque fois ajoutée au mot de données ancien (TRACK), déterminé dans l'étape de calcul précédente, et
f) le nouveau mot de données ancien (TRACK) ainsi calculé est utilisé dans l'étape de calcul suivante c) ou bien e) en tant que mot de données ancien (TRACK) de l'étape de calcul précédente.

3. Procédé selon la revendication 1 ou 2, **caractérisé en ce que** la fonction de mise à l'échelle est formée par division et la fonction de suppression d'échelle est formée par multiplication par le facteur de mise à l'échelle, la division par n, ou bien la multiplication par n, étant effectuée par n fois un décalage vers la droite ou bien vers la gauche au niveau du bit.

4. Procédé selon la revendication 1 ou 2, **caractérisé en ce que** la fonction de mise à l'échelle est formée par formation de puissance à la base 2.

5. Procédé selon les revendications 1 à 4, **caractérisé en ce que,** pour la compression, pour chaque valeur de différence mise à l'échelle, un échelon de quantification, associé à cette valeur, est extrait d'une table de quantification et en ce que, pour la décompression, une valeur décodée est affectée à chaque valeur codée par l'intermédiaire d'une table de décodage.

6. Procédé selon la revendication 5, **caractérisé en ce que** les échelons de la table de quantification ou bien de la table de décodage sont choisis sensiblement en fonction des échelons d'un histogramme d'un fragment vocal à haute voix.

7. Procédé selon les revendications 1 à 6, **caractérisé en ce que,** dans l'étape b), un facteur de mise à l'échelle (S), extrait d'une table de mise à l'échelle, est associé à la valeur maximale des valeurs de différence.

8. Procédé selon la revendication 7, **caractérisé en ce que** le facteur de mise à l'échelle est affecté de telle manière que le saut de quantification, le plus grand disponible, atteigne 80 % de la plus grande valeur de différence.

9. Procédé selon l'une des revendications 1 à 8, **caractérisé en ce que,** pour la décompression du signal comprimé dans une opération de calcul, qui se répète pour chaque mot de données du groupe, les étapes d) et e) ainsi qu'une étape f1) sont exécutées, cette dernière consistant en ce que
f1) le nouveau mot de données ancien (TRACK) ainsi calculé est utilisé, dans l'étape de calcul e) de l'opération de calcul suivante, en tant que mot de données ancien (TRACK) de l'étape de calcul précédente.
